# EUROPEAN PATENT SPECIFICATION

(11) **EP 3 812 830 B1**
(45) Date of publication and mention of the grant of the patent: **17.07.2024**
(21) Application number: 19822787.8
(22) Date of filing: 20.06.2019
(51) Int. Cl.: G02B 5/08, G02F 1/13, G09F 9/00, H04N 13/302, H05B 33/14, G02B 5/124, G02B 5/136, G02B 27/01, G02B 30/56, G02B 5/09, G09F 19/16, G09F 9/30

(54) **AERIAL DISPLAY DEVICE**
LUFTANZEIGEVORRICHTUNG
DISPOSITIF D'AFFICHAGE AÉRIEN

(30) Priority: 21.06.2018 JP 2018117917
(43) Date of publication of application: 28.04.2021
(73) Proprietor: Toppan Printing Co., Ltd., Tokyo 110-0016 (JP)
(72) Inventor: DAIKU, Yasuhiro, Tokyo 110-0016 (JP)
(74) Representative: TBK
(86) International application number: PCT/JP2019/024561
(87) International publication number: WO 2019/244992

(56) References cited:
- EP-B1- 0 742 911
- JP-A- 2011 242 729
- JP-A- 2011 242 729
- JP-A- 2016 101 805
- JP-A- 2017 181 555
- JP-A- 2017 181 555

## Description

### FIELD

The present invention relates to an aerial display apparatus.

### BACKGROUND

An aerial display apparatus capable of displaying an image, a moving image, etc. as an aerial image has been studied and is expected as a new human-machine interface. The aerial display apparatus reflects light emitted from a display device and forms a real image (hereinafter, an "aerial image") in the air using, for example, a dihedral corner reflector array in which dihedral corner reflectors are arranged in an array (see, for example, Patent Document JP 2017 - 67 933 A). In the display method using the dihedral corner reflector array, aberration does not occur, and a real image is displayed at a plane-symmetrical position.

Document JP 2011 - 242 729 A discloses a display apparatus that uses a real mirror image forming optical system to display to an observer a combination of a real image of a subject and a projection image on a screen surface which is included in the real mirror image forming optical system. The display apparatus comprises: a wall for defining an observer side space; a subject positioned in a subject side space that is separated by a portion of the wall; a real mirror video image forming optical system that separates the observer side space and subject side space as a portion of the wall, has a semipermeable substrate including symmetric surfaces, and focuses a real image of the subject in the observer side space via the substrate; a screen surface that is arranged in the substrate facing the observer side space and has a diffusion reflection function; and a projecting optical system for projecting a projection image on the screen surface in the observer side space.

Document JP 2017 - 181 555 A discloses another display apparatus which comprises: a liquid crystal module constituted by integrating a back light with a first liquid crystal cell; a second liquid crystal cell arranged in front of the first liquid crystal cell in parallel with the first liquid crystal cell with a space S in-between; a holder holding peripheral edge parts of the first and second liquid crystal cells; a light guide body arranged at an inner wall of the holder facing the space S, and a light source which makes light be incident on the light guide body. The display device is configured to perform stereoscopic display by displaying images of the first liquid crystal cell and second liquid crystal cell one over the other, turns on the light source to make the light pass through the inside of the light guide body and make the light be emitted from an outer wall surface.

Document EP 0 742 911 B1 discloses an apparatus for providing optical illusion effects comprising: a stage area disposed between a rear projection screen and a viewing area; a variable illuminating system for the stage area; a partially inclined silvered mirror positioned between the viewing area and the stage area; a second projection screen positioned above the inclined mirror and parallel to the plane of the stage area; a first projection means for projecting images on the rear projection screen; a second projection means for projecting images on the second projection screen so that images can be viewed from the viewing area via the inclined mirror; means for changing between images from the projection means so that viewers may be presented an image from either or both projection means at any one time.

### SUMMARY

### TECHNICAL PROBLEM

It is an object of the invention to provide an aerial display apparatus capable of displaying an aerial image above an image display surface of a display device and improving the display quality of both an image on the image display surface and the aerial image.

### SOLUTION TO PROBLEM

This object is achieved by an aerial display apparatus according to claim 1. Advantageous further developments are as set forth in the dependent claims.

### BRIEF DESCRIPTION OF THE DRAWINGS

FIG. 1 is a perspective view of a mirror device.
FIG. 2 is a schematic diagram showing principles of an aerial display apparatus.
FIG. 3 is a schematic diagram showing a state of light that is reflected twice by a single optical element of the mirror device.
FIG. 4 is a diagram showing an optical path when the optical element shown in FIG. 3 is viewed from a z direction.
FIG. 5 is a diagram showing an optical path when the optical element shown in FIG. 3 is viewed from a y direction.
FIG. 6 is a diagram showing an optical path when the optical element shown in FIG. 3 is viewed from an x direction.
FIG. 7 is a schematic diagram showing a ghost displayed by the aerial display apparatus.
FIG. 8 is a schematic diagram showing a state of light that is reflected once by a single optical element.
FIG. 9 is a diagram showing an optical path when the optical element shown in FIG. 8 is viewed from the z direction.
FIG. 10 is a diagram showing an optical path when the optical element shown in FIG. 8 is viewed from the y direction.
FIG. 11 is a diagram showing an optical path when the optical element shown in FIG. 8 is viewed from the x direction.
FIG. 12 is a schematic diagram showing unwanted light of the aerial display apparatus.
FIG. 13 is a schematic diagram showing a state of light that is not reflected at all by a single optical element.
FIG. 14 is a diagram showing an optical path when the optical element shown in FIG. 13 is viewed from the z direction.
FIG. 15 is a diagram showing an optical path when the optical element shown in FIG. 13 is viewed from the y direction.
FIG. 16 is a diagram showing an optical path when the optical element shown in FIG. 13 is viewed from the x direction.
FIG. 17 is a block diagram showing a configuration of the aerial display apparatus according to an embodiment.
FIG. 18 is a perspective view showing an optical configuration of the aerial display apparatus according to the embodiment.
FIG. 19 is a side view showing an optical configuration of the aerial display apparatus according to the embodiment.
FIG. 20 is a layout diagram of an optical element in a mirror device in the aerial display apparatus.
FIG. 21 is a diagram showing an optical path when the optical element shown in FIG. 20 is viewed from the z direction.
FIG. 22 is a perspective view showing a configuration of a display unit in the aerial display apparatus.
FIG. 23 is a plan view of a liquid crystal display device as a display device in the display unit.
FIG. 24 is a cross-sectional view of the liquid crystal display device shown in FIG. 23.
FIG. 25 is a cross-sectional view of a transparent organic EL display device as a display unit.
FIG. 26 is a diagram showing a display example displayed on an aerial display apparatus for vehicle use.
FIG. 27 is a schematic diagram showing an optical configuration of an aerial display apparatus according to a comparative example.

### DETAILED DESCRIPTION

Hereinafter, embodiments will be described with reference to the drawings. The drawings are schematic or conceptual, and the dimensions, ratios, and the like of each drawing are not necessarily the same as the actual ones. Even when the same portions are shown in the drawings, the dimensional relationship and the ratio may be different. In particular, several embodiments described below exemplify an apparatus and a method for embodying the technical idea of the present invention, and the technical idea of the present invention is not specified by the shape, structure, arrangement, or the like of the components. In the following description, elements having the same function and configuration will be denoted by the same reference numerals, and redundant descriptions will be made only when necessary.

Before describing the aerial display apparatus of the present embodiment, the principles of the aerial display apparatus will be described.

### [1] Principles of Aerial Display Apparatus

An aerial display apparatus is configured to form an image of light emitted from a display surface of, for example, a liquid crystal display in the air, using an aerial imaging device (mirror device) such as a dihedral corner reflector.

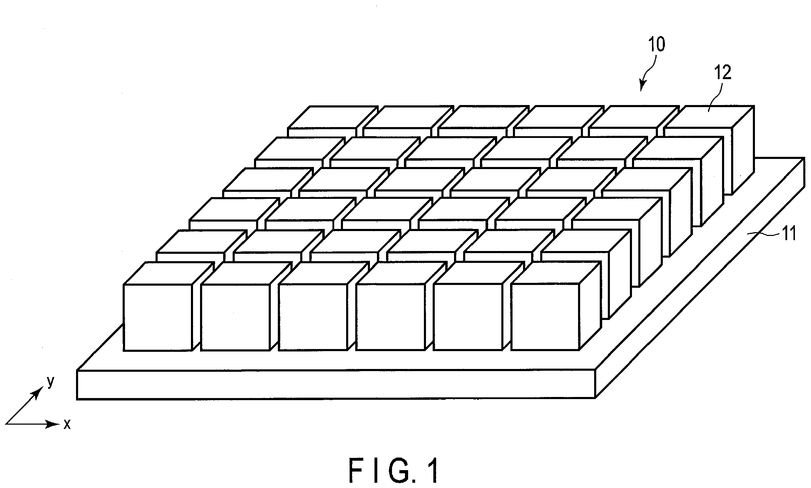

A configuration of a mirror device 10 used in the aerial display apparatus will be described. FIG. 1 is a perspective view of the mirror device 10.

The mirror device 10 includes a planar base material 11 and a plurality of optical elements 12 provided on the base material 11. The optical elements 12 are arranged, for example, in a matrix so as to extend in an x direction and a y direction that are orthogonal to each other. Each of the optical elements 12 has two reflective surfaces that are disposed at right angles. Each optical element 12 is in a cubic or rectangular parallelepiped shape. The base material 11 and the optical elements 12 are configured of a transparent resin.

In FIG. 1, 36 (= 6 × 6) optical elements 12 are shown as an example; however, in actuality, a greater number of optical elements 12 are disposed. The number and size of the optical elements 12 can be freely set according to the specifications of the aerial display apparatus. A distance between two optical elements 12 can be freely set according to the specifications of the aerial display apparatus.

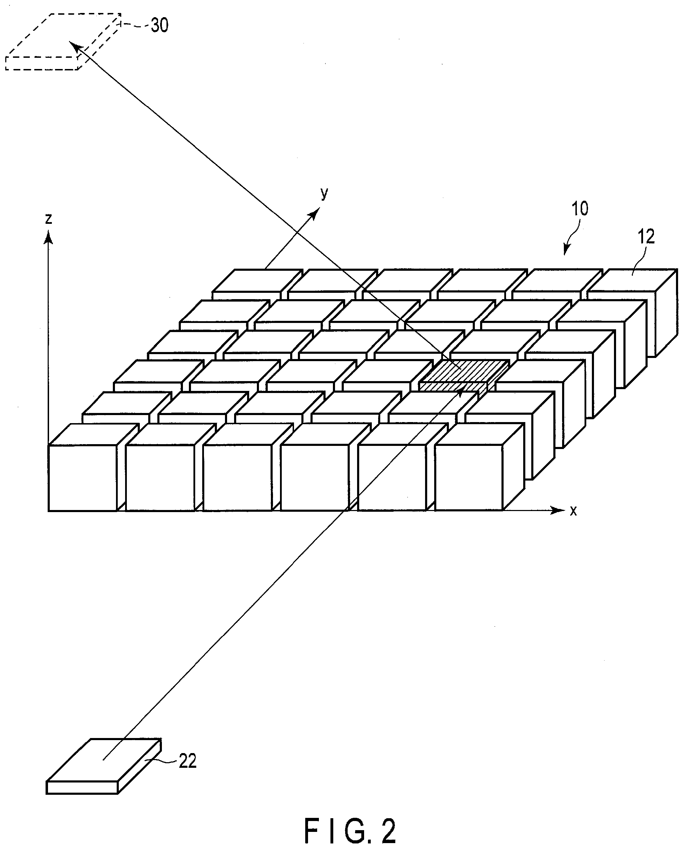

FIG. 2 is a schematic diagram showing principles of the aerial display apparatus. The aerial display apparatus includes a display device 22 that displays an image on a display surface and a mirror device 10. In FIG. 2, the base material 11 of the mirror device 10 is not illustrated, and only the optical elements 12 are extracted for illustration, for ease of understanding of the drawing. The optical elements 12 are arranged on an x-y plane. The z direction is a direction that is orthogonal to the x and y directions, and is a height direction of the optical elements 12.

Light (display light) emitted from the display device 22 is reflected by two side surfaces of each of the optical elements 12. In FIG. 2, the optical path of light that has been reflected by the hatched optical element 12 is extracted for illustration. The light emitted from the display device 22 is formed into an image at a position that is plane-symmetrical to the display device 22 with respect to the mirror device 10, and an aerial image 30 is formed at that position (hereinafter, "display position"). An observer can visually recognize the aerial image 30.

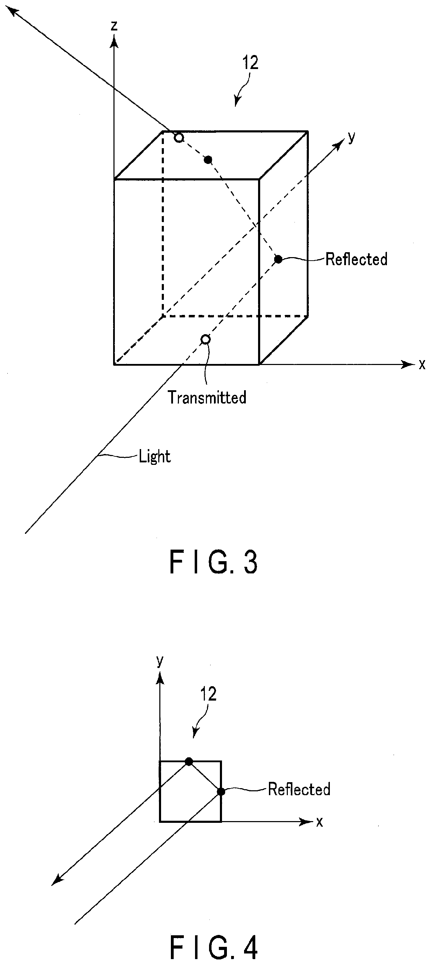

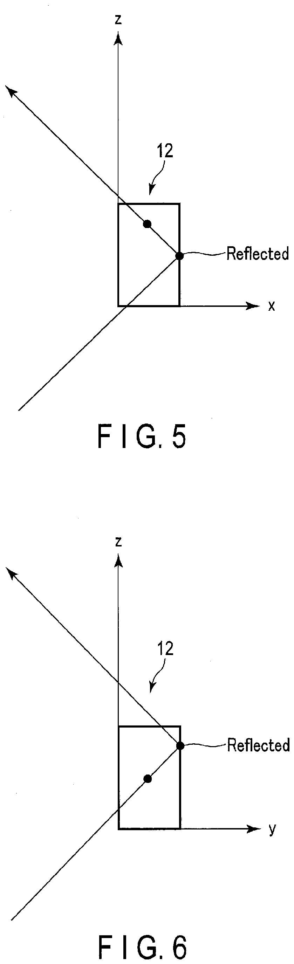

FIG. 3 is a schematic diagram showing a state of light that is reflected twice by a single optical element 12. FIG. 4 is a diagram showing an optical path when the optical element 12 is viewed from the z direction. FIG. 5 is a diagram showing an optical path when the optical element 12 is viewed from the y direction. FIG. 6 is a diagram showing an optical path when the optical element 12 is viewed from the x direction.

Light that has been made incident from a bottom surface of the optical element 12 is reflected by a first side surface, further reflected by a second side surface that is at right angles to the first side surface, and then emitted from a top surface.

It should be noted that not all the light components of light that has been made incident on a given side surface of the optical element 12 are reflected by that side surface, and the light is divided into a reflective component and a transmissive component. The reflective component is a component of light that has been reflected by the side surface at an angle of reflection corresponding to the angle of incidence, and the transmissive component is a component of light that is linearly transmitted through that side surface.

### (Regarding ghosts)

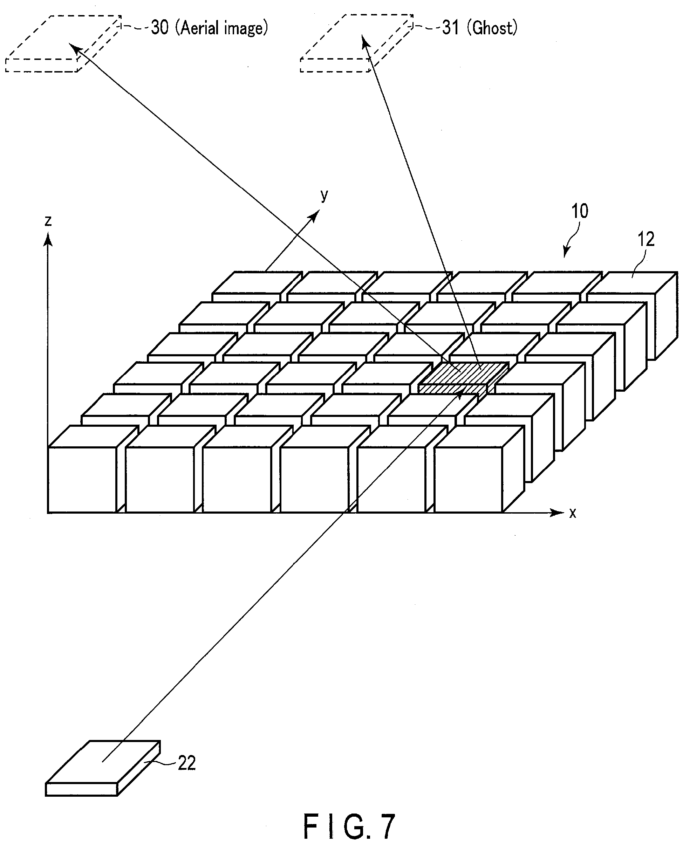

Next, a ghost that is formed at an unintended position will be described. A ghost is a double image that appears in the vicinity of the aerial image 30. FIG. 7 is a schematic diagram showing a ghost 31 displayed by the aerial display apparatus.

The ghost 31 is an image formed by light that is reflected only once (i.e., light that is not reflected twice) by the mirror device 10. The ghost 31 is formed at a position that is not plane-symmetrical to the display device 22 with respect to the mirror device 10.

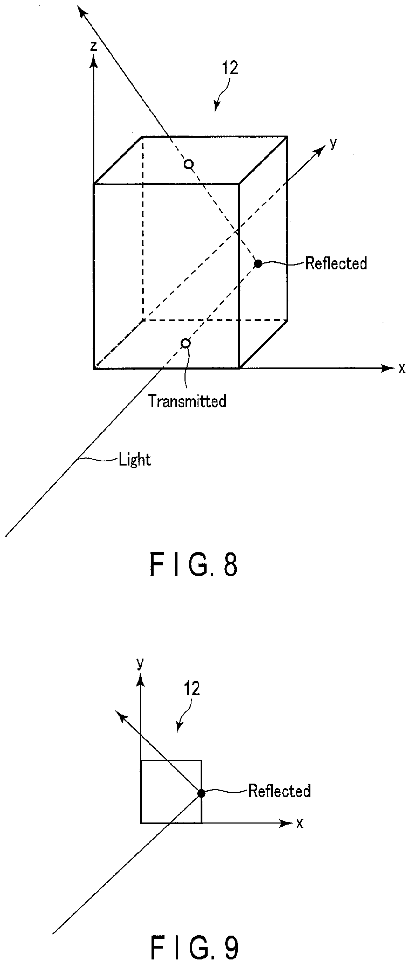

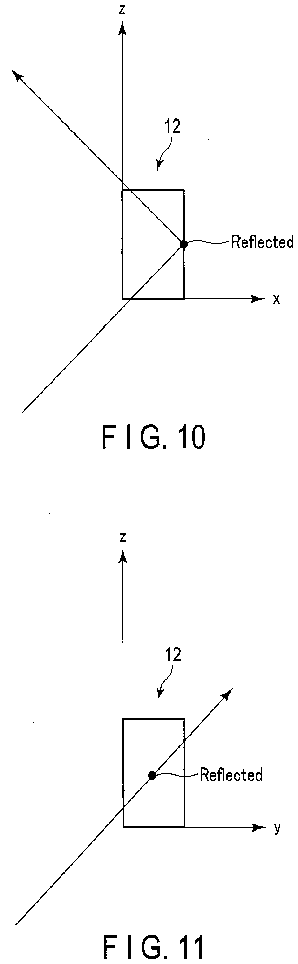

FIG. 8 is a schematic diagram showing a state of light that has been reflected once by a single optical element 12. FIG. 9 is a diagram showing an optical path when the optical element 12 is viewed from the z direction. FIG. 10 is a diagram showing an optical path when the optical element 12 is viewed from the y direction. FIG. 11 is a diagram showing an optical path when the optical element 12 is viewed from the x direction.

Light that has been made incident from a bottom surface of the optical element 12 is reflected by a first side surface, and is then transmitted through a second side surface that is at right angles to the first side surface. The light that travels along this path is formed into an image at a position that is not plane-symmetrical to the display device 22 with respect to the mirror device 10, thereby displaying a ghost 31.

### (Regarding unwanted light)

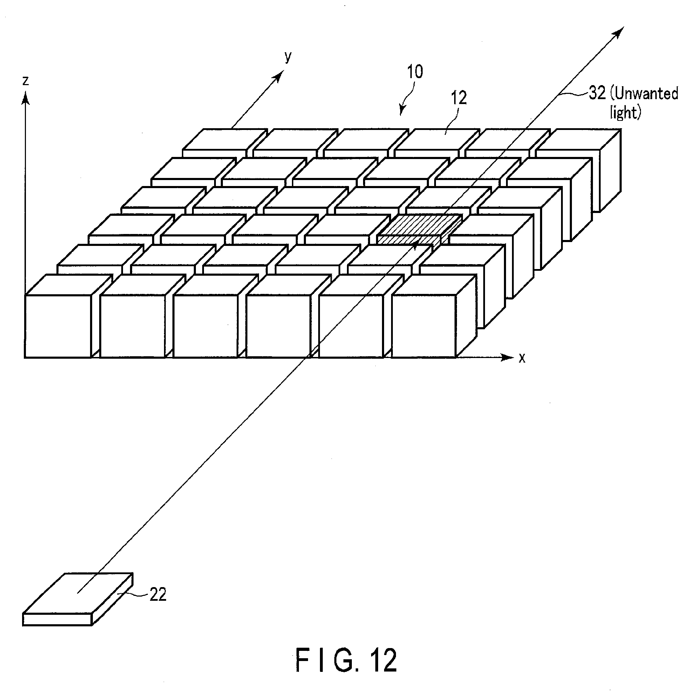

Next, unwanted light will be described. Unwanted light is a light component that does not contribute to formation of a real image. FIG. 12 is a schematic diagram showing unwanted light 32 of the aerial display apparatus.

The unwanted light 32 is light that is not reflected at all by the mirror device 10. The unwanted light 32 is linearly transmitted through the mirror device 10.

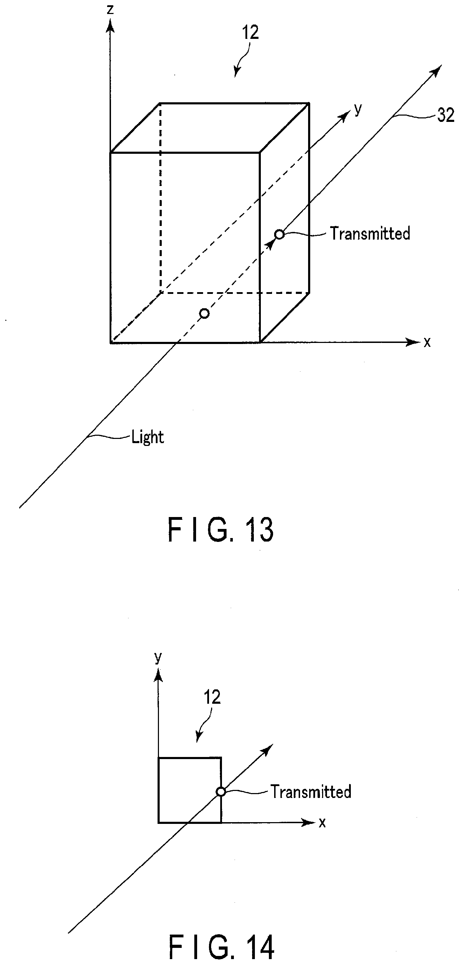

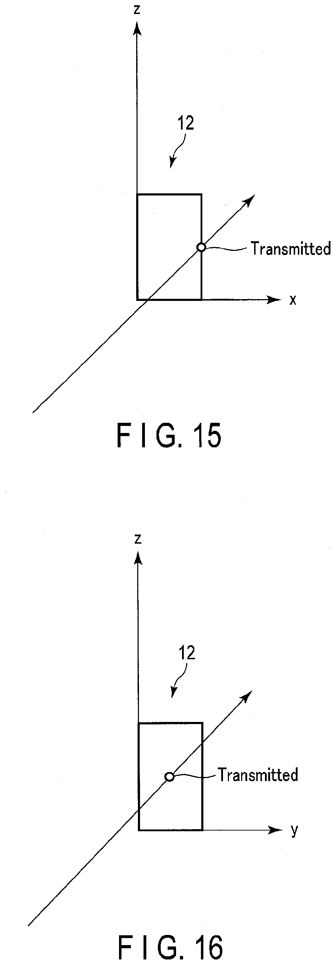

FIG. 13 is a schematic diagram showing a state of light that is not reflected at all by a single optical element 12. FIG. 14 is a diagram showing an optical path when the optical element 12 is viewed from the z direction. FIG. 15 is a diagram showing an optical path when the optical element 12 is viewed from the y direction. FIG. 16 is a diagram showing an optical path when the optical element 12 is viewed from the x direction.

The light that has been made incident from the bottom surface of the optical element 12 is not reflected by the first side surface, and is linearly transmitted through the first side surface.

The unwanted light 32 brightens the periphery of the aerial image 30. Due to the unwanted light 32, the contrast of the aerial image 30 is reduced.

### [2] Aerial Display Apparatus according to Embodiment

Next, an aerial display apparatus according to an embodiment using the above-described principles will be described.

### [2-1] Configuration of Aerial Display Apparatus

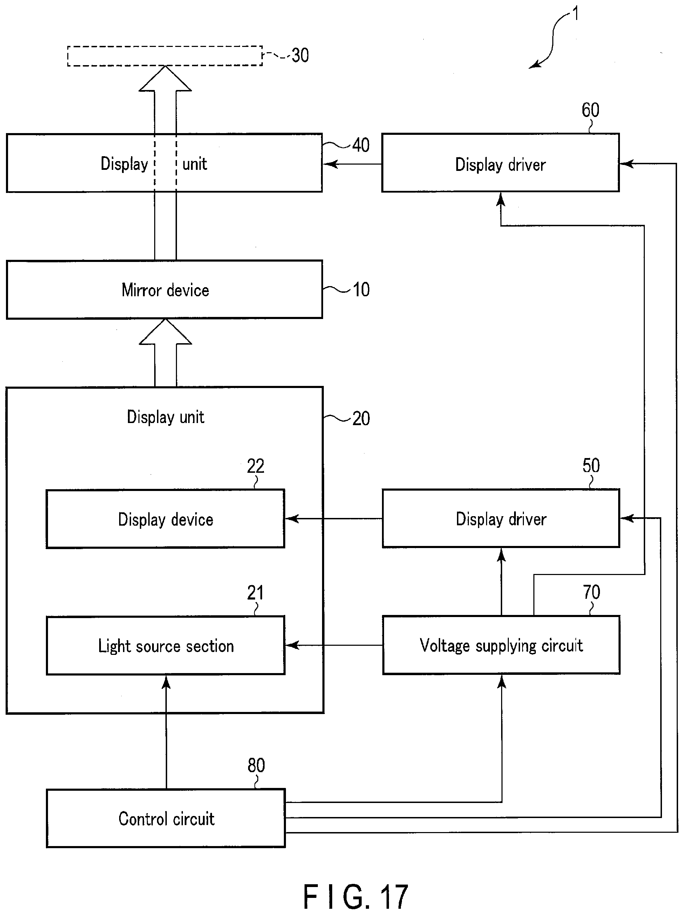

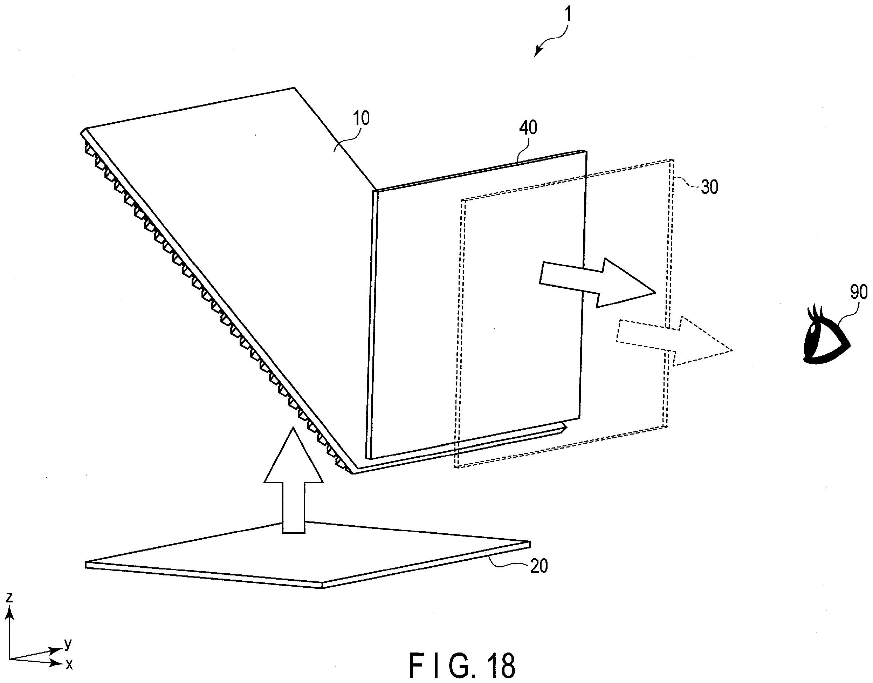

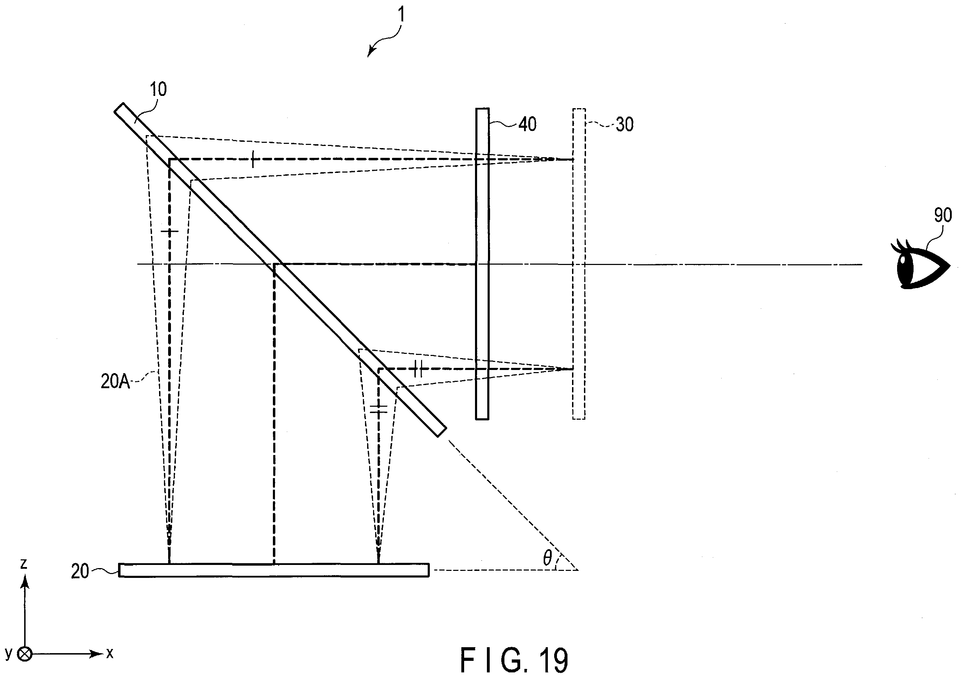

A configuration of the aerial display apparatus 1 of the embodiment will be described with reference to FIGS. 17 and 18. FIG. 17 is a block diagram showing a configuration of the aerial display apparatus 1 according to the embodiment. FIG. 18 is a perspective view showing an optical configuration of the aerial display apparatus 1. FIG. 19 is a side view showing the optical configuration.

As shown in FIGS. 17 to 19, the aerial display apparatus 1 includes a display unit 20, a mirror device 10, a display unit 40, display drivers 50 and 60, a voltage supplying circuit 70, and a control circuit 80.

As shown in FIGS. 18 and 19, a display surface of the display unit 20 is disposed, for example, in parallel to the x-y plane. As shown in FIG. 19, a principal surface of the mirror device 10 on which the optical elements 12 are arranged is disposed obliquely, for example, at 45 degrees with respect to a z direction that is orthogonal to the x-y plane. In other words, the principal surface of the mirror device 10 is disposed obliquely, for example, at 45 degrees with respect to the display surface of the display unit 20. That is, the angle θ formed by the display surface of the display unit 20 and the principal surface of the mirror device 10 is, for example, 45 degrees. The angle θ is not limited to 45 degrees, and can be set within the range of 30 degrees to 60 degrees.

The angle formed by the principal surface of the mirror device 10 and the display surface of the display unit 40 is also set to, for example, the angle θ. In the example of FIG. 18, the display unit 40 is disposed, for example, in parallel to a y-z plane that is orthogonal to the x direction. The display unit 40 is disposed on an optical path of light emitted from the mirror device 10.

The light emitted from the display unit 20 is reflected by the mirror device 10. The light that has been reflected by the mirror device 10 is transmitted through the image display surface of the display unit 40, and is formed into a real image (aerial image) 30 in the air at a position between the display unit 40 and the observer 90. That is, the display unit 40 is disposed between the mirror device 10 and the aerial image 30, and the aerial image 30 is formed above the image display surface of the display unit 40 on the side of the observer 90.

The display unit 20 includes a light source section 21 and a display device 22. The light source section 21 includes a planar light source that emits planar light, and applies the planar light to the display device 22. The display device 22 allows the light emitted from the light source section 21 to be transmitted therethrough, and displays an image, a moving image, or the like indicating desired information. That is, the display device 22 emits light (hereinafter, "display light") for displaying an image, a moving image, or the like as an aerial image using the light emitted from the light source section 21. Details of the display unit 20 will be described later.

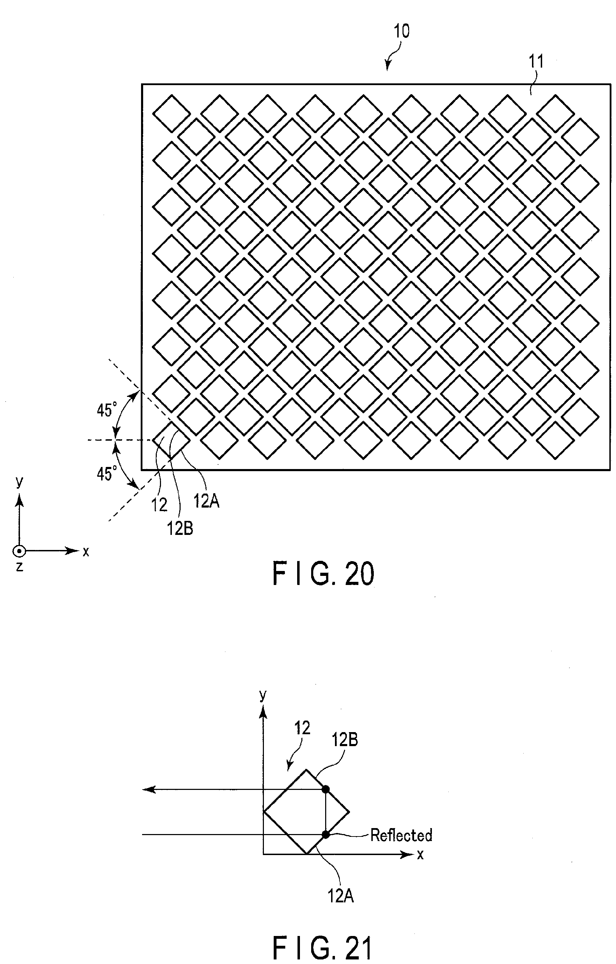

As described above, the mirror device 10 includes a plurality of optical elements 12 provided on the base material 11. FIG. 20 is a diagram showing a layout of a plurality of optical elements 12 on a base material 11, in which the optical elements 12 are viewed from the z direction through the base material 11. Each optical element 12 is in the shape of a cube or a rectangular parallelepiped having diagonal vertexes in the x and y directions, and the optical elements 12 are arranged in the x and y directions. In other words, each of the optical elements 12 shown in FIGS. 1 to 6 is rotated by 45 degrees with respect to the x direction, and the mirror device 10 of FIG. 20 is obtained. As shown in FIG. 20, the reflective surfaces 12A and 12B of each optical element 12 are disposed at an angle of 45 degrees with respect to the x direction.

FIG. 21 is a diagram showing an optical path when the optical element 12 shown in FIG. 20 is viewed from the z direction. The display light that has been made incident from a bottom surface of the optical element 12 is reflected by a reflective surface 12A, further reflected by a reflective surface 12B that is at right angles to the reflective surface 12A, and emitted from an upper surface.

The display unit 40 is a transmissive display device that allows light that has been made incident on a rear surface to be transmitted therethrough. The display unit 40 includes an image display surface on which an image, a moving image, or the like, is displayed, and allows the display light emitted from the mirror device 10 to be transmitted therethrough. That is, the display unit 40 displays its own image in front of the image of the display unit 20. Details of the display unit 40 will be described later.

The display driver 50 drives the display device 22 to display an image, a moving image, or the like on the display device 22. The display driver 60 drives the display unit 40 to cause the display unit 40 to display an image, a moving image, or the like on its image display surface. The voltage supplying circuit 70 generates voltages required to operate the light source section 21 and the display drivers 50 and 60, and supplies the generated voltages to the light source section 21 and the display drivers 50 and 60. The control circuit 80 controls the operation of the entire aerial display apparatus 1. That is, the control circuit 80 controls the light source section 21, the display drivers 50 and 60, and the voltage supplying circuit 70 to cause the display unit 40 to display an image, a moving image, or the like, and to cause the aerial image 30 to be displayed at a display position between the display unit 40 and the observer 90.

### [2-1-1] Display Unit 20

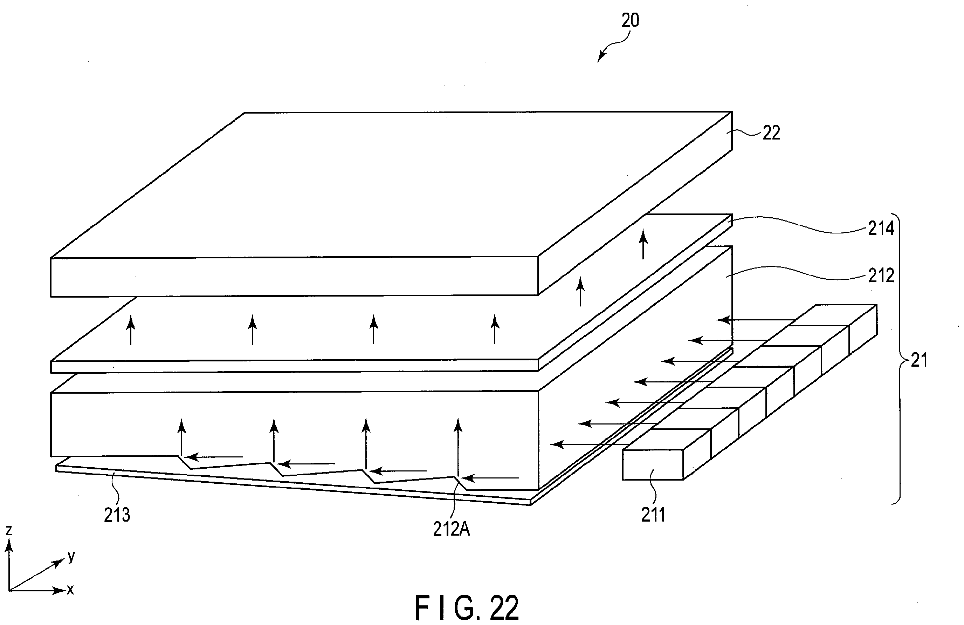

Next, the display unit 20 in the aerial display apparatus 1 will be described with reference to FIG. 22. FIG. 22 is a perspective view showing a configuration of the display unit 20. As described above, the display unit 20 includes a light source section 21 and a display device 22.

The light source section 21 is configured of a side-light type (edge-light type) backlight. The light source section 21 includes one or more light-emitting devices 211, a light guide plate 212, a reflective sheet 213, and a diffusive sheet 214. The light source section 21 constitutes a surface light source by the light-emitting device 211, the light guide plate 212, the reflective sheet 213, and the diffusive sheet 214, and emits planar light to the display device 22.

For the light-emitting device 211, a light-emitting diode (LED), for example, is used. The light-emitting diode emits, for example, white light. The light-emitting device 211 is disposed so as to face a side surface (or an incident surface) of the light guide plate 212. A reflective sheet 213 is provided on a bottom surface of the light guide plate 212. The diffusive sheet 214 is provided on an upper surface of the light guide plate 212. The display device 22 is disposed on an optical path of light emitted from the diffusive sheet 214.

As shown in FIG. 22, light emitted from the light-emitting device 211 is made incident on a side surface of the light guide plate 212. A bottom surface of the light guide plate 212 functions as a surface that reflects light. The bottom surface of the light guide plate 212 has a plurality of reflective surfaces 212A that are arranged obliquely with respect to the horizontal direction (x-y plane), that is, has a staircase shape (corrugated pattern). The light that has been transmitted through the light guide plate 212 is reflected by the reflective surfaces 212A toward the diffusive sheet 214. The reflective sheet 213 reflects the light that has been transmitted through the bottom surface of the light guide plate 212, and returns the light to the light guide plate 212. The light that has been emitted from the upper surface of the light guide plate 212 and made incident on the diffusive sheet 214 is diffused by the diffusive sheet 214, and emitted from the upper surface of the diffusive sheet to the display device 22.

The display device 22 displays an image, a moving image, or the like. The display device 22 allows the light received from the light source section 21 to be transmitted therethrough, and emits display light 20A for displaying an image, a moving image, or the like at a display position in the air. That is, the display device 22 modulates light from the light source section 21, and emits display light 20A for an image, a moving image, or the like.

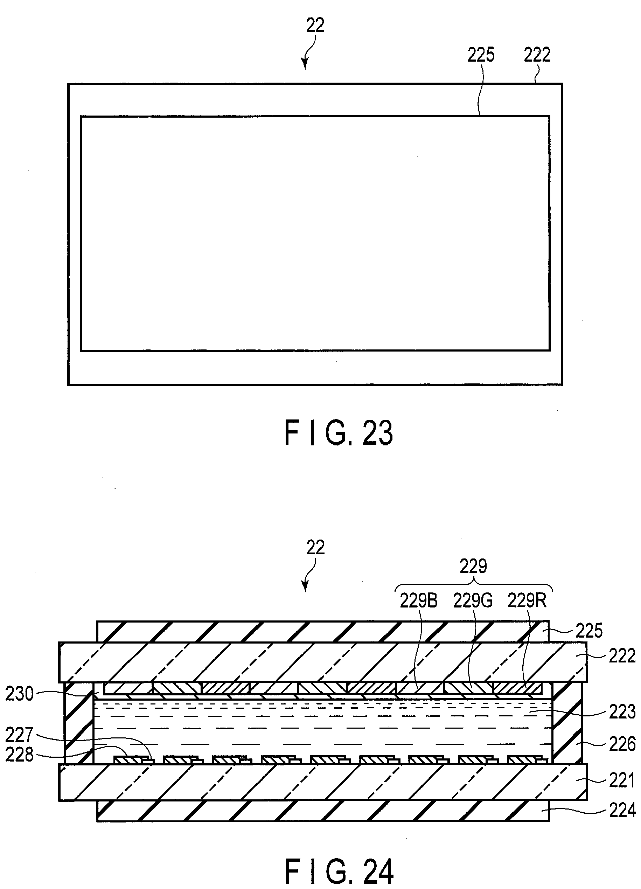

The display device 22 is configured using, for example, a liquid crystal display device. An example of the liquid crystal display device will be described below. FIG. 23 is a plan view of a liquid crystal display device as the display device 22, and FIG. 24 is a cross-sectional view of the liquid crystal display device.

The display device 22 includes a TFT substrate 221 on which Thin Film Transistors (TFTs), pixel electrodes, and the like are formed, a Color Filter (CF) substrate 222 on which a color filter, a common electrode, and the like are formed and which is disposed to face the TFT substrate 221, and a liquid crystal layer 223 interposed between the TFT substrate 221 and the CF substrate 222.

Each of the TFT substrate 221 and the CF substrate 222 is configured of a transparent substrate (e.g., a glass substrate). A polarizing plate 224 is disposed on a surface of the TFT substrate 221 that is opposite to the surface on which the liquid crystal layer 223 is present. Furthermore, a polarizing plate 225 is disposed on a surface of the CF substrate 222 that is opposite to the surface on which the liquid crystal layer 223 is present.

The TFT substrate 221 is disposed so as to face the light source section 21. Illumination light that has been emitted from the light source section 21 enters the liquid crystal display device from the side of the TFT substrate 221. The surface of the CF substrate 222 that is opposite to a surface on which the light source section 21 is disposed is a display surface or a light emission surface of the liquid crystal display device.

The TFT substrate 221 and the CF substrate 222 are attached to each other by a seal member 226, with a space kept therebetween. A liquid crystal material is sealed in a space surrounded by the TFT substrate 221, the CF substrate 222, and the seal member 226 to form a liquid crystal layer 223.

In the liquid crystal material contained in the liquid crystal layer 223, the alignment of the liquid crystal molecules is operated in accordance with an electric field applied between the TFT substrate 221 and the CF substrate 222, resulting in a change in optical characteristics. The liquid crystal layer 23 is configured of a liquid crystal layer including liquid crystal molecules having dielectric anisotropies, and is configured of, for example, nematic liquid crystals. Liquid crystal molecules of nematic liquid crystals are electrically polarized in response to an external electric field. Examples of the liquid crystal mode that may be used include a vertical alignment (VA) mode; however, other liquid crystal modes such as a twisted nematic (TN) mode and a homogeneous mode may be used, as a matter of course.

A plurality of switching elements, such as the above-described thin-film transistors (TFTs) 227 are provided on the side of the liquid crystal layer 223 of the TFT substrate 221. The TFT 227 includes a gate electrode electrically connected to a scanning line, a gate insulating film provided on the gate electrode, a semiconductor layer (for example, an amorphous silicon layer) provided on the gate insulating film, and a source electrode and a drain electrode separately provided on the semiconductor layer. The source electrode is electrically connected to a signal line. An insulating layer (not shown) is provided on the TFT 227. A plurality of pixel electrodes 228 are provided on the insulating layer.

A color filter 229 is provided on the side of the liquid crystal layer 223 of the CF substrate 222. The color filter 229 includes a plurality of coloring filters (coloring members). Specifically, a plurality of red filters 229R, a plurality of green filters 229G, and a plurality of blue filters 229B are provided. A general color filter is configured of red (R), green (G), and blue (B), which are the three primary colors of light. A set of three adjacent colors, R, G, and B constitutes a display unit (pixel), and a single-color portion of any one of R, G, and B in a single pixel constitutes the minimal driving unit called a "sub-pixel". The TFT 227 and the pixel electrode 228 are provided for each sub-pixel. In the description that follows, a sub-pixel is referred to as a "pixel" unless it is particularly necessary to distinguish between a pixel and a sub-pixel.

A black matrix (light-shielding film) (not shown) for shielding light is provided at a boundary portion of the red filter 229R, the green filter 229G, and the blue filter 229B, and a boundary portion of the pixels (sub-pixels). That is, the black matrix is formed in a mesh pattern. The black matrix is provided, for example, to shield unwanted light between coloring members and to improve the contrast.

A common electrode 230 is provided on the color filter 229 and the black matrix. The common electrode 230 is formed in a planar shape over the entire display region of the liquid crystal display device.

The polarizing plates 224 and 225 are provided so as to interpose the TFT substrate 221 and the CF substrate 222. Each of the polarizing plates 224 and 225 is configured of a linear polarizer and a 1/4-wavelength plate.

The pixel electrode 228 and the common electrode 230 are formed of transparent electrodes using, for example, indium tin oxides (ITO).

### [2-1-2] Display Unit 40

The display unit 40 is configured of a self-luminous and transmissive display device. The display unit 40 displays an image, a moving image, or the like by using light emitted by itself, and allows the display light from the mirror device 10 to be transmitted therethrough. For the display unit 40, various transmissive display devices may be used, such as a transparent organic electroluminescence (EL) display device, a transparent inorganic EL display device, and a transmissive liquid crystal display device with a side-light type backlight. Herein, a transparent organic EL display device will be described as an example of the self-luminous and transmissive display device.

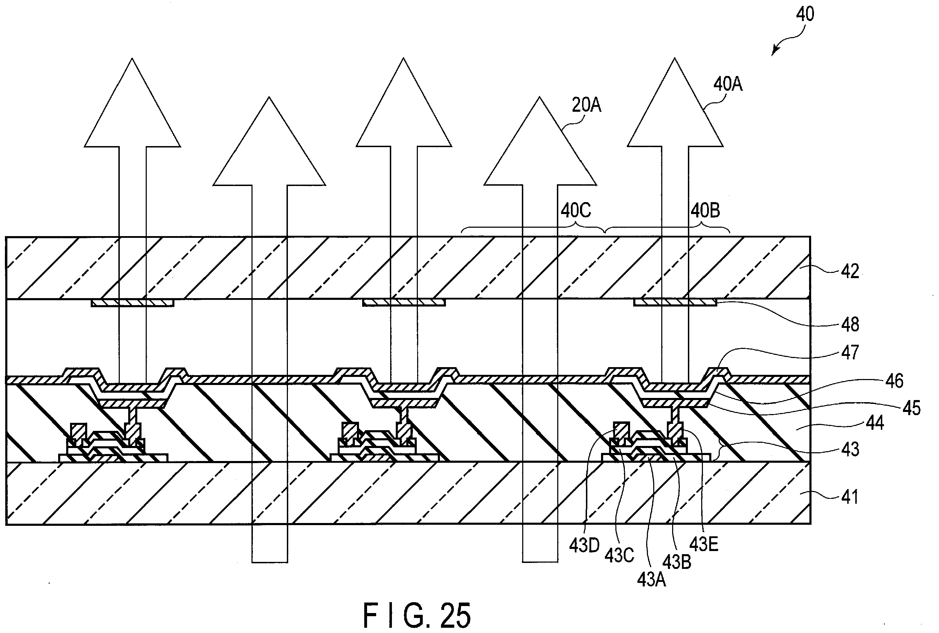

FIG. 25 is a cross-sectional view of a transparent organic EL display device as the display unit 40. The transparent organic EL display device includes substrates 41 and 42, a plurality of switching elements such as TFTs 43, an insulating layer 44, a pixel electrode 45, an organic layer 46, a common electrode 47, and a color filter 48, which are provided between the substrates 41 and 42.

Each of the substrates 41 and 42 is configured of a transparent substrate (e.g., a glass substrate or plastic) or a transparent film. A plurality of TFTs 43 are provided on the substrate 41. Each TFT 43 includes a gate electrode 43A electrically connected to a scanning line, a gate insulating film 43B provided on the gate electrode 43A, a semiconductor layer (e.g., an amorphous silicon layer) 43C provided on the gate insulating film 43B, and a source electrode 43D and a drain electrode 43E separately provided on the semiconductor layer 43C. The source electrode 43D is electrically connected to a signal line.

An insulating layer 44 is provided on the TFT 43. A plurality of pixel electrodes 45 are provided on the insulating layer 44. Each pixel electrode 45 is electrically connected to the drain electrode 43E of the TFT 43 via a contact plug. An organic layer 46 is provided on each pixel electrode 45. A common electrode 47 is provided on the organic layers 46. A color filter 48 is provided above the common electrode 47 so as to correspond to each organic layer 46. A substrate 42 is provided on the color filter 48. A sealed air layer is provided between the common electrode 47 and the substrate 42.

The transparent organic EL display device includes a light-emitting region 40B that emits light 40A, and a transmissive region 40C that allows a display light 20A to be transmitted therethrough. In the light-emitting region 40B, the TFT 43, the pixel electrode 45, the organic layer 46, the common electrode 47, and the color filter 48 are disposed between the substrate 41 and the substrate 42, and light 40A can be emitted from the organic layer 46. In the transmissive region 40C, a common electrode 47 is disposed. Since the common electrode 47 is configured of a transparent electrode (e.g., ITO), the display light 20A that has been made incident on the substrate 41 of the transmissive region 40C is passed through the common electrode 47, and is emitted from the substrate 42.

In the display unit 40, a plurality of TFTs 43 are controlled to an ON state or an OFF state by the control circuit 80 via the display driver 60. When the TFT 43 is turned on, a voltage is applied to the pixel electrode 45, and a potential difference is generated between the pixel electrode 45 and the common electrode 47, causing light to be emitted from the organic layer 46. When the TFT 43 is turned off, a voltage is not applied to the pixel electrode 45, and light is not emitted from the organic layer 46.

The transmissive region 40C provided between the light-emitting regions 40B allows the display light 20A that has been emitted from the mirror device 10 to be transmitted therethrough. The display light 20A that has been transmitted through the transmissive region 40C is formed into an aerial image 30 at the display position.

### [2-2] Display Operation of Aerial Display Apparatus 1

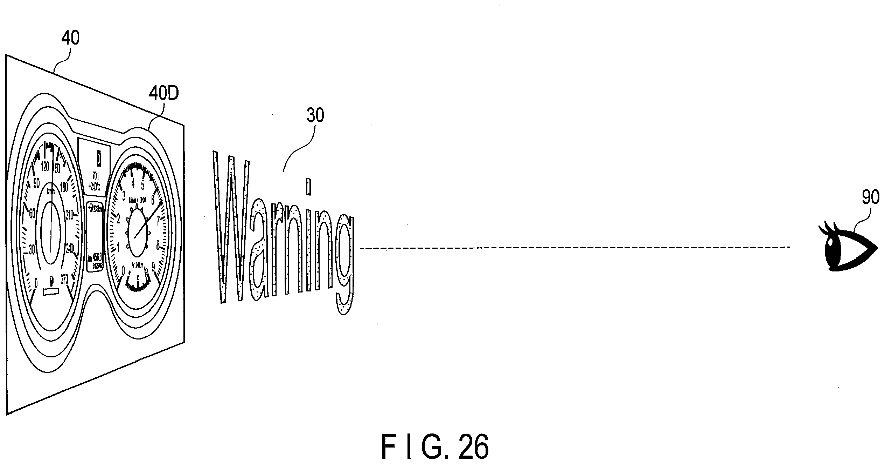

Next, a display operation of the aerial display apparatus according to the embodiment will be described with reference to FIGS. 19 and 26. FIG. 19 is a diagram showing an optical configuration of the aerial display apparatus 1, as described above. FIG. 26 is a diagram showing a display example displayed on an aerial display apparatus 1 for vehicle use.

As shown in FIG. 19, the display light 20A is emitted from the display unit 20 to the mirror device 10. The display light 20A that has been made incident on the mirror device 10 is reflected by the optical element 12 included in the mirror device 10, as described with reference to FIG. 21. The light that has been reflected by the optical element 12 is transmitted through the image display surface of the display unit 40, and is formed into an aerial image 30 at the display position between the display unit 40 and the observer 90. That is, the display light 20A emitted from the display unit 20 is formed into an image at a display position that is plane-symmetrical to the image displayed on the display device 20 with respect to the mirror device 10, and the aerial image 30 is displayed at the display position, as shown in FIG. 26. Moreover, an image 40D is displayed on the image display surface of the display unit 40.

Thereby, the aerial image 30 is displayed above the image 40D of the display unit 40. The observer 90 can visually recognize a display in which the image 40D and the aerial image 30 overlap each other. For example, as shown in FIG. 26, the observer 90 can visually recognize an overlapping display of a speedometer and a tachometer displayed as the image 40D and a warning display displayed as the aerial image 30.

### [3] Advantageous Effects of Embodiment

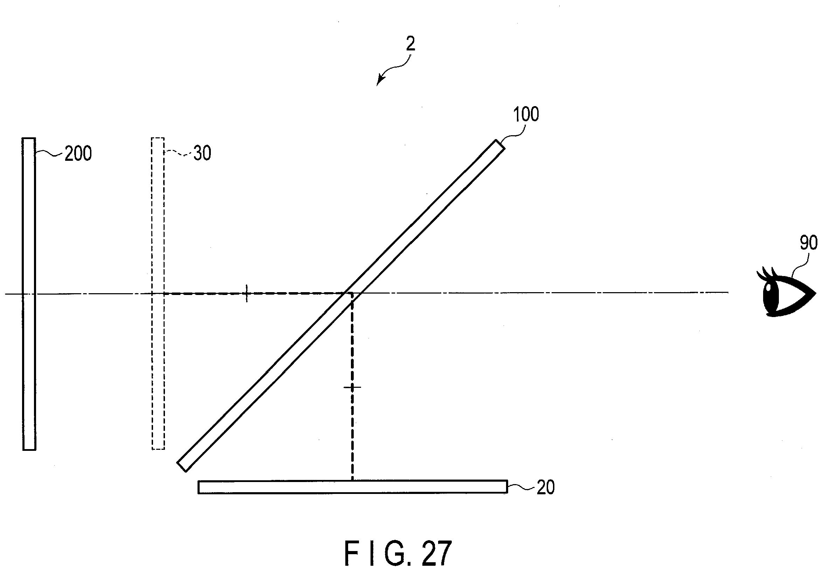

Before describing the advantageous effects of the embodiment in detail, an aerial display apparatus of a comparative example will be described below. FIG. 27 is a schematic diagram showing an optical configuration of an aerial display apparatus according to a comparative example. In the comparative example, a semitransparent mirror 100 is arranged obliquely on an optical path of the light emitted from the display unit 20. Moreover, a display unit 200 is arranged at the back (or a rear direction) of the semitransparent mirror 100. The light emitted from the display unit 20 is reflected by the semitransparent mirror 100 in the direction of the observer 90. The observer 90 visually recognizes the aerial image 30 at the back of the semitransparent mirror 100 with the light that has been reflected by the semitransparent mirror 100. Moreover, an image is displayed on the display unit 200 disposed at the back of the aerial image 30. Thereby, the observer 90 can visually recognize a display in which an image of the display unit 200 and the aerial image 30 overlap each other.

In the comparative example, the light from the display unit 20 is reflected by the semitransparent mirror 100, and is formed into an aerial image 30. Accordingly, the aerial image 30 is displayed at a position that is plane-symmetrical to the display unit 20 via the semitransparent mirror 100. Thus, the aerial image 30 and the image of the display unit 200 are arranged at the back of the semitransparent mirror 100. As a result, the observer 90, who visually recognizes the image of the display unit 200 and the aerial image 30 via the semitransparent mirror 100, might not visually recognize these images favorably.

The aerial display apparatus according to the embodiment comprises a display unit (display device) 20 which includes a display surface on which a first image is displayed and which emits display light from the display surface; a mirror device 10 which is disposed obliquely with respect to the display surface of the display unit 20, which reflects the display light emitted from the display unit 20, and which forms an aerial image 30 at a position that is plane-symmetrical to the display unit 20; and a display unit (display device) 40 which is arranged between the mirror device 10 and the aerial image 30, which allows the display light that has been reflected by the mirror device 10 to be transmitted therethrough, and which displays a second image.

With such a configuration, the display light emitted from the display unit 20 is reflected by the mirror device 10, transmitted through the display surface of the display unit 40, and formed into an aerial image 30 at a position between the display unit 40 and the observer 90. Moreover, a second image is displayed on the display unit 40. Thereby, the aerial image 30 is displayed above the second image of the display unit 40, and the second image and the aerial image 30 are displayed in an overlapping manner. The observer 90 can visually recognize the overlapping display of the second image and the aerial image 30 directly, without using a semitransparent mirror or the like.

According to the aerial display apparatus 1 of the embodiment described above, it is possible to display an aerial image above an image display surface of the display unit (display device), and to improve the display quality of both an image on the image display surface and the aerial image. In other words, the aerial display apparatus 1 of the embodiment is capable of displaying an aerial image in front of the image display surface of the display unit, as viewed from the observer, thus improving the visibility to the observer of the image on the image display surface and the aerial image.

An example of a product field in which the aerial display apparatus is used will be described below. In the field of an instrument panel of an automobile, for example, a conventional mechanical meter type is being replaced with an image display surface such as an electronic display capable of displaying various types of information. By presenting an aerial display image in front of the image display surface, a new display means can be proposed. As an example, a behavior of a driver who drives an automobile will be taken as an example. The driver checks the instrument panel while checking the front and surrounding conditions through the windshield to grasp the vehicle conditions (e.g., the vehicle body speed, the engine or the motor rotation speed, the fuel remaining amount or the power condition, or the like). When, for example, speeding or the like occurs during driving, the driver's attention can be more effectively called by making an attention-calling display in a space in front of (on the driver side of) the image display surface of the instrument panel, rather than on the same plane as the image display surface of the instrument panel. As a result, an effect of preventing an unfortunate accident such as a traffic accident can be expected.

### REFERENCE SIGNS LIST

1...Aerial display apparatus, 10...Mirror device, 11...Base material, 12...Optical element, 12A, 12B...Reflective surface, 20...Display unit, 20A...Display light, 21...Light source section, 22...Display device, 30...Aerial image, 40...Display unit, 40A...Light, 40B...Light-emitting region, 40C...Transmissive region, 40D...Image, 50, 60...Display driver, 70...Voltage supplying circuit, 80...Control circuit, 90...Observer, 211...Light-emitting device, 212...Light guide plate, 212A...Reflective surface, 213...Reflective sheet, 214...Diffusive sheet.

## Claims

1. An aerial display apparatus (1) comprising:
a first display device (20) which includes a display surface on which a first image is displayed, and which is configured to emit display light from the display surface;
a mirror device (10) which is disposed obliquely with respect to the display surface of the first display device (20), which is configured to reflect the display light that has been emitted from the first display device (20) to form an aerial image (30) at a position that is plane-symmetrical to the first display device (20); and
a second display device (40) which is disposed between the mirror device (10) and the aerial image (30), which is configured to allow the display light that has been reflected by the mirror device (10) to be transmitted therethrough, and which is configured to display a second image
**characterized in that** the second display device (40) is separate from the mirror device (10), and
the aerial image (30) is formed in front of the second image as viewed from an observer on a side closer to the observer than the mirror device (10).

2. The aerial display apparatus (1) according to claim 1, wherein the mirror device (10) includes a plurality of optical elements (12) each including two reflective surfaces that are disposed at right angles.

3. The aerial display apparatus (1) according to claim 2, wherein each of the optical elements (12) is in a cubic or rectangular parallelepiped shape.

4. The aerial display apparatus (1) according to claim 1, wherein an angle formed by a principal surface of the mirror device (10) and the display surface of the first display device (20) is equal to or greater than 30 degrees and equal to or smaller than 60 degrees.

5. The aerial display apparatus (1) according to claim 4, wherein the angle formed by a principal surface of the mirror device (10) and the display surface of the first display device (20) is 45 degrees.

6. The aerial display apparatus (1) according to claim 1, wherein the second display device (40) is a transmissive display device that is configured to allow the display light that has been reflected by the mirror device (10) to be transmitted therethrough.

7. The aerial display apparatus (1) according to claim 6, wherein the second display device (40) is a transparent EL display device.

## Patentansprüche

1. Luftanzeigevorrichtung (1) mit:
einer ersten Anzeigevorrichtung (20), die eine Anzeigeoberfläche umfasst, auf der ein erstes Bild angezeigt wird, und die konfiguriert ist, ein Anzeigelicht von der Anzeigeoberfläche zu emittieren;
einer Spiegelvorrichtung (10), die in Bezug auf die Anzeigeoberfläche der ersten Anzeigevorrichtung (20) schräg angeordnet ist, die konfiguriert ist, das Anzeigelicht, das von der ersten Anzeigevorrichtung (20) emittiert worden ist, zu reflektieren, um ein Luftbild (30) bei einer Position zu erzeugen, die zu der ersten Anzeigevorrichtung (20) ebenen-symmetrisch ist; und
einer zweiten Anzeigevorrichtung (40), die zwischen der Spiegelvorrichtung (10) und dem Luftbild (30) angeordnet ist, die konfiguriert ist, es dem Anzeigelicht, das durch die Spiegelvorrichtung (10) reflektiert worden ist, zu ermöglichen, dort hindurch übertragen zu werden, und die konfiguriert ist, ein zweites Bild anzuzeigen,
**dadurch gekennzeichnet, dass** die zweite Anzeigevorrichtung (40) von der Spiegelvorrichtung (10) getrennt ist, und
das Luftbild (30), wenn es von einem Beobachter betrachtet wird, vor dem zweiten Bild auf einer Seite erzeugt wird, die näher zu dem Beobachter als der Spiegelvorrichtung (10) ist.

2. Luftanzeigevorrichtung (1) nach Anspruch 1, wobei die Spiegelvorrichtung (10) eine Vielzahl von optischen Elementen (12) umfasst, von denen jedes zwei reflektierende Oberflächen umfasst, die bei rechten Winkeln angeordnet sind.

3. Luftanzeigevorrichtung (1) nach Anspruch 2, wobei jedes der optischen Elemente (12) in einer kubischen oder rechteckigen Parallelepipedform ist.

4. Luftanzeigevorrichtung (1) nach Anspruch 1, wobei ein Winkel, der durch eine Hauptoberfläche der Spiegelvorrichtung (1) und die Anzeigeoberfläche der ersten Anzeigevorrichtung (20) gebildet wird, größer oder gleich 30 Grad und kleiner oder gleich 60 Grad ist.

5. Luftanzeigevorrichtung (1) nach Anspruch 4, wobei der Winkel, der durch eine Hauptoberfläche der Spiegelvorrichtung (10) und die Anzeigeoberfläche der ersten Anzeigevorrichtung (20) gebildet wird, 45 Grad ist.

6. Luftanzeigevorrichtung (1) nach Anspruch 1, wobei die zweite Anzeigevorrichtung (40) eine lichtdurchlässige Anzeigevorrichtung ist, die konfiguriert ist, es dem Anzeigelicht, das durch die Spiegelvorrichtung (10) reflektiert worden ist, zu ermöglichen, dort hindurch übertragen zu werden.

7. Luftanzeigevorrichtung (1) nach Anspruch 6, wobei die zweite Anzeigevorrichtung (40) eine transparente EL-Anzeigevorrichtung ist.

## Revendications

1. Appareil d'affichage aérien (1) comprenant :
un premier dispositif d'affichage (20) qui comprend une surface d'affichage sur laquelle une première image est affichée, et qui est configuré pour émettre une lumière d'affichage à partir de la surface d'affichage ;
un dispositif de miroir (10) disposé obliquement par rapport à la surface d'affichage du premier dispositif d'affichage (20), qui est configuré pour réfléchir la lumière d'affichage qui a été émise par le premier dispositif d'affichage (20) afin de former une image aérienne (30) à une position symétrique en plan par rapport au premier dispositif d'affichage (20) ; et
un second dispositif d'affichage (40) disposé entre le dispositif de miroir (10) et l'image aérienne (30), qui est configuré pour permettre à la lumière d'affichage qui a été réfléchie par le dispositif de miroir (10) d'être transmise à travers celui-ci, et qui est configuré pour afficher une seconde image
**caractérisé en ce que** le second dispositif d'affichage (40) est séparé du dispositif de miroir (10), et
l'image aérienne (30) est formée devant la seconde image vue par un observateur sur un côté plus proche de l'observateur que le dispositif de miroir (10).

2. Appareil d'affichage aérien (1) selon la revendication 1, dans lequel le dispositif de miroir (10) comprend une pluralité d'éléments optiques (12) comprenant chacun deux surfaces réfléchissantes disposées en angle droit.

3. Appareil d'affichage aérien (1) selon la revendication 2, dans lequel chacun des éléments optiques (12) a une forme de parallélépipède cubique ou rectangulaire.

4. Appareil d'affichage aérien (1) selon la revendication 1, dans lequel un angle formé par une surface principale du dispositif de miroir (10) et la surface d'affichage du premier dispositif d'affichage (20) est égal ou supérieur à 30 degrés et égal ou inférieur à 60 degrés.

5. Appareil d'affichage aérien (1) selon la revendication 4, dans lequel l'angle formé par une surface principale du dispositif de miroir (10) et la surface d'affichage du premier dispositif d'affichage (20) est de 45 degrés.

6. Appareil d'affichage aérien (1) selon la revendication 1, dans lequel le second dispositif d'affichage (40) est un dispositif d'affichage transmissif configuré pour permettre à la lumière d'affichage qui a été réfléchie par le dispositif de miroir (10) d'être transmise à travers celui-ci.

7. Appareil d'affichage aérien (1) selon la revendication 6, dans lequel le second dispositif d'affichage (40) est un dispositif d'affichage EL transparent.
